# EUROPÄISCHE PATENTSCHRIFT

(11) **EP 0 854 367 B1**
(45) Veröffentlichungstag und Bekanntmachung des Hinweises auf die Patenterteilung: **16.06.2004**
(21) Anmeldenummer: 98100584.6
(22) Anmeldetag: 15.01.1998
(51) Int. Cl.: G01R 33/28

(54) **MR-Verfahren zur bildgestützten Überwachung der Verschiebung eines Objektes und MR-Anordnung zur Durchführung des Verfahrens**
MR method of an image-based control of the displacement of an object and MR apparatus for carrying out the method
Méthode de RM de surveillance assistée par imagerie du déplacement d'un objet et appareil de RM pour l'exécution de la méthode

(30) Priorität: 15.01.1997 DE 19701036
(43) Veröffentlichungstag der Anmeldung: 22.07.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Holz, Dietrich J.K., Dr., Röntgenstrasse 24, 22335 Hamburg (DE)
(74) Vertreter: Volmer, Georg, Dipl.-Ing.

(56) Entgegenhaltungen:
- EP-A- 0 619 498
- DE-A- 19 507 617
- G. MCKINNON: "Tracking and Monitoring the Effects of Interventional MR Instruments" SOCIETY OF MAGNETIC RESONANCE, 3RD MEETING, Bd. 1, 1995, XP002062589

## Beschreibung

Die Erfindung betrifft ein MR-Verfahren nach dem Oberbegriff des Anspruchs 1. Ein solches MR-Verfahren ist aus Proceedings of 3rd SMR, 490, 1995 bekannt. Die Aufnahme eines MR-Datensatzes für ein Angiogramm dauert relativ lange (8 Min. bis 20 Min.). Deshalb wird dieser MR-Datensatz aufgenommen, bevor das Objekt - z.B. ein Katheter - in das Gefäßsystem eingeführt wird. Nach der Einführung des Katheters wird die Position des Objektes fortlaufend in Echtzeit gemessen und in ein aus dem ersten MR-Datensatz abgeleitetes MR-Angiogramm eingeblendet.

Das bekannte Verfahren stößt an seine Grenzen, wenn der Patient sich während der Intervention bewegt. Die in Echtzeit gemessene Position des Objekts kann dann nicht mehr an der richtigen Stelle in das Angiogramm eingeblendet werden, weil die Bewegung des Patienten in dem Angiogramm keinen Niederschlag gefunden hat.

Aufgabe der vorliegenden Erfindung ist es daher, ein Verfahren der Eingangs genannten Art so zu verbessern, daß die Position des Objekts relativ zum Gefäßsystem auch bei einer Bewegung des Patienten richtig dargestellt wird.

Diese Aufgabe wird erfindungsgemäß durch die im Anspruch 1 angegebenen Maßnahmen gelöst.

Die Erfindung basiert auf der Überlegung, daß man mit Hilfe des quasi in Echtzeit akquirierten Schichtbildes die Bewegung bzw. die Verschiebung des Patienten quantitativ bestimmen kann, indem man dieses Schichtbild mit einem MR-Bild derselben Schicht vergleicht, das aus dem ersten Datensatz oder einem zweiten, nahezu gleichzeitig mit dem ersten akquirierten Datensatz abgeleitet wird. Deshalb kann die Position des Objekts im MR-Angiogramm oder das MR-Angiogramm selbst korrigiert werden, in der Weise, daß trotz der Bewegung das Objekt in der richtigen Position relativ zum Gefäßsystem dargestellt wird.

An dieser Stelle sei erwähnt, daß aus der DE-A 195 07 617 bereits ein MR-Verfahren mit den Schritten a) und b) des Anspruchs 1 bekannt ist. Dieses Verfahren dient der Einblendung der Position eines chirurgischen Instruments in ein Schichtbild, dessen MR-Signale quasi gleichzeitig mit der Messung der Position des Instruments ermittelt werden. Die Probleme, die sich ergeben können, wenn die Position des Instrument in ein dreidimensionales MR-Angiogramm eingeblendet werden soll und der Patient sich zwischen der Akquisition der dafür erforderlichen MR-Daten und der Messung der Position des Instruments bewegt hat, sind in dem Dokument nicht angesprochen.

Wenn die Sequenzen, mit denen der erste MR-Datensatz akquiriert wird, wesentlich von denjenigen Sequenzen abweichen, mit denen während der Verschiebung des Objektes die MR-Daten für die einzelnen Schichtbilder akquiriert werden, können Strukturen in dem Schichtbild einerseits und in einem aus dem ersten Datensatz abgeleiteten MR-Bild andererseits mit unterschiedlichem Kontrast wiedergegeben werden. In diesem Fall wäre es nicht möglich, aus einem Vergleich der beiden Bilder die Verschiebung zu ermitteln, die zwischen der Akquisition des ersten MR-Datensatzes und der Akquisition der MR-Daten für das Schichtbild stattgefunden hat, so daß die gemessene Position des Objekts und/oder das MR-Angiogramm nicht mehr entsprechend der Verschiebung korrigiert werden könnte. In diesem Fall muß in zeitlicher Nähe zu dem ersten Datensatz ein zweiter MR-Daten akquiriert werden. Die Vergleichbarkeit der verschiedenen Bilder läßt sich dadurch sicherstellen, daß der zweite MR-Datensatz und die MR-Daten für die verschiedenen Schichten mit gleichartigen Anregungssequenzen akquiriert werden.

Eine bevorzugte Weiterbildung der Erfindung sieht vor, daß zur Messung der Position des Objekts wenigstens eine mit dem Objekt verbundene Mikrospule vorgesehen ist, daß zur Akquisition der MR-Daten der Schicht eine Anzahl von Anregungssequenzen erzeugt wird, wobei die Richtung des während der Erfassung des MR-Signales wirksamen magnetischen Gradientenfeldes von Sequenz zu Sequenz variiert wird und daß die Position des Objekts aus MR-Signalen abgeleitet wird, die bei diesen Sequenzen von der Mikrospule empfangen werden. Die bei dieser sogenannten Projektions-Rekonstruktionsmethode erzeugten Sequenzen gestatten gleichzeitig die Messung der Position des Objekts mit Hilfe der damit verbundenen Mikrospule und die Erzeugung eines MR-Schichtbildes - mit Hilfe einer zusätzlichen Empfangsspule, die die dabei erzeugten MR-Signale aufnimmt.

Eine Anordnung zur Durchführung des erfindungsgemäßen Verfahrens ist in Anspruch 4 angegeben.

Die Erfindung wird nachfolgend anhand der Zeichnungen näher erläutert. Es zeigen:
Fig. 1 ein MR-Gerät, mit dem das erfindungsgemäße Verfahren ausgeführt werden kann,
Fig. 2 ein Ablaufdiagramm zur Erläuterung des erfindungsgemäßen Verfahrens,
Fig. 3 den zeitlichen Verlauf verschiedener Signale bei der Akquisition des ersten MR-Datensatzes,
Fig. 4 den zeitlichen Verlauf verschiedener Signale bei der Akquisition der MR-Daten für eine Schicht und
Fig. 5 verschiedene Bilder, die aus dem MR-Datensatz bzw. den MR-Daten abgeleitet sind.

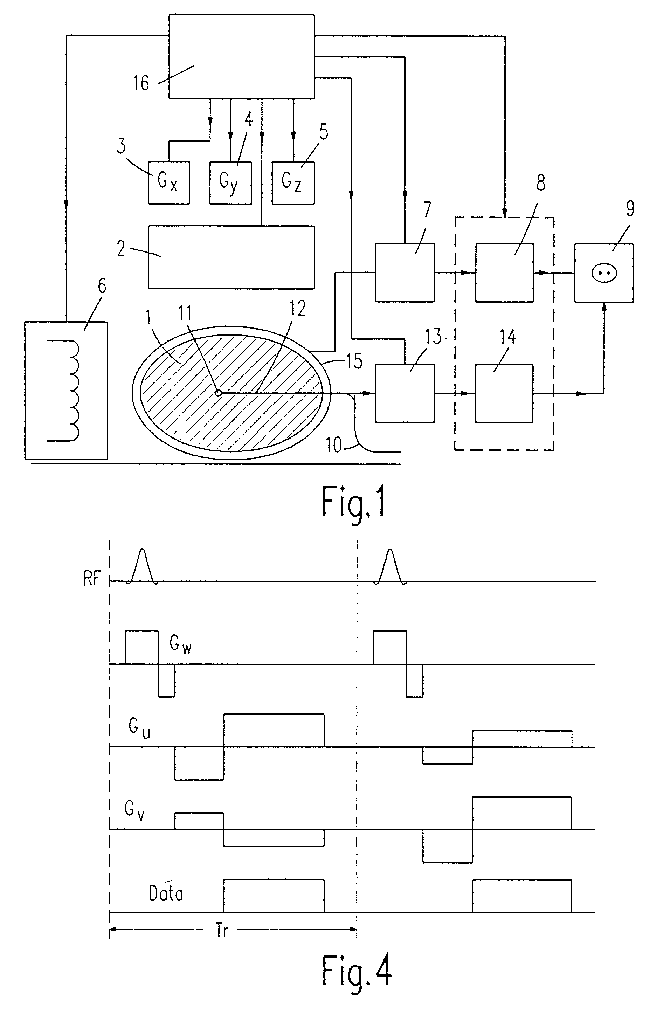

In Fig. 1 ist mit 1 ein Untersuchungsobjekt bezeichnet z.B. ein Patient. In diesen Patienten ist ein Katheter 10 eingeführt, dessen Lage in bezug auf das Gefäßsystem des Patienten überwacht werden soll. In dem Untersuchungsbereich, in dem sich der Patient befindet, wird ein stationäres homogenes Magnetfeld mit einer Stärke von z.B. 1,5 Tesla mit Hilfe eines Hauptfeldmagneten 2 erzeugt. Drei Gradientenspulen 3, 4 und 5 erzeugen Magnetfelder, die sich in x, y bzw. z-Richtung linear ändern (und daher im folgenden auch als Gradientenfelder bezeichnet werden) und die in Richtung des homogenen stationären Magnetfeldes verlaufen.

Außerdem ist eine Hochfrequenz-Sendespule 6 vorgesehen, mit der Hochfrequenzimpulse erzeugt werden können, durch die im Untersuchungsbereich ein zum stationären Magnetfeld senkrechtes Hochfrequenz-Magnetfeld entsteht. Die dabei im Untersuchungsbereich bzw. im Untersuchungsobjekt entstehenden MR-Signale werden von einer MR-Spule 15 empfangen, und von einem ersten MR-Empfänger 7 in MR-Daten umgesetzt, aus denen mittels einer Rekonstruktionseinheit 8 die Kernmagnetisierungsverteilung im Untersuchungsbereich rekonstruiert werden kann. Die so ermittelte Verteilung kann mittels einer Wiedergabeeinheit 9 (Monitor) dargestellt werden.

Die Position des Katheters 10 kann in bekannter Weise mittels einer an dessen Spitze befestigten Mikrospule 11 ermittelt werden, die MR-Signale aus einem sehr kleinen Umgebungsbereich aufnehmen kann. Diese MR-Signale werden von einem zweiten MR-Empfänger 13 in MR-Daten umgesetzt, aus denen in bekannter Weise mittels einer Recheneinheit 14 die Position der Mikrospule und damit die Position der Spitze des Katheters ermittelt werden kann. Diese Position kann in bekannter Weise in das MR-Bild auf der Wiedergabeeinheit 9 eingeblendet werden. Die Komponenten 2-14 sind von einer Steuereinheit 16 steuerbar.

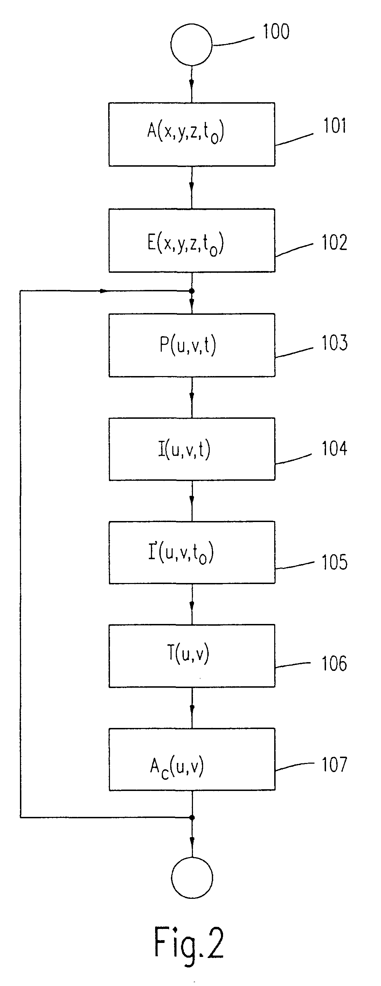

Im folgenden wird das mit dem MR-Gerät nach Fig. 1 durchgeführte Verfahren anhand des Ablaufdiagramms in Fig. 2 näher erläutert, entsprechend dem die Steuereinheit 16 den zeitlichen Ablauf des Verfahrens steuert. Nach der Initialisierung im Block 100 wird ein erster MR-Datensatz A(x,y,z,t₀) akquiriert, der den räumlichen Verlauf des Gefäßsystems des Patienten innerhalb eines dreidimensionalen Bereichs darstellt (Block 101). Diese Akquisition erfolgt zweckmäßig vor der Einführung des Katheters in den Patienten.

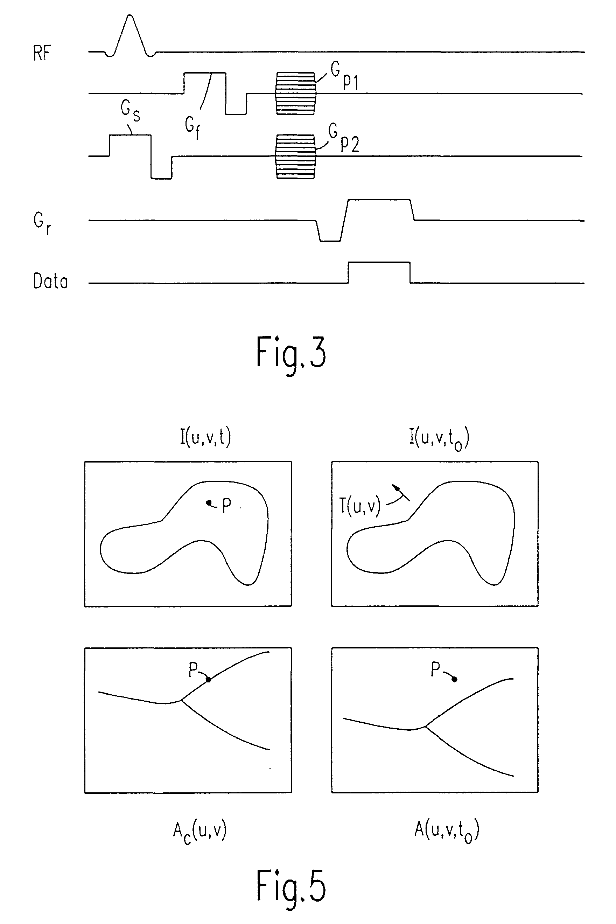

Fig. 3 zeigt den zeitlichen Verlauf verschiedener Signale bei einem für diese Zwecke geeigneten unter der Bezeichnung PCA (phase contrast angiography) bekannten MR-Verfahren. In der ersten Zeile ist die zeitliche Lage eines Hochfrequenzimpulses dargestellt und zeitgleich damit ein Schichtselektionsgradient Gₛ (3. Zeile). Dem Hochfrequenzimpuls folgen zwei Phasenkodier-Gradienten Gₚ₁ und Gₚ₂ (2. und 3. Zeile), die von je einer der drei Gradientenspulen Anordnung 3.... 5 erzeugt sein können. Danach wird ein Lesegradient Gᵣ ein- und ausgeschaltet (4. Zeile), und die dabei auftretenden MR-Signale werden von dem phasenempfindlichen ersten MR-Empfänger 7 akquiriert (5. Zeile). Von dem bekannten 3DFT-Verfahren unterscheidet sich das PCA-Verfahren dadurch, daß zusätzlich ein Flußkodierungs-Gradient G_{f} eingefügt ist, wodurch das im Gefäßsystem fließende Blut eine von Richtung und Flußgeschwindigkeit abhängige Phasenkodierung erhält. Es werden darüber hinaus weitere Gruppen von Sequenzen erzeugt, bei denen der Flußkodierungs-Gradient in einer anderen der drei Raumrichtungen verläuft und schließlich eine weitere Gruppe ohne jede Flußkodierung. Die Akquisition dieses ersten MR-Datensatz dauert relativ lange - je nach der Zahl der Phasenkodierungsschritte zwischen 8 und 25 Minuten.

Wie dem Artikel von M. Kouwenhoven et al. "Current MR Angiography Imaging Techniques, A Survey" in dem Buch "Vascular Diagnostics", edited by P. Lanzer and J.Rösch, Springer Verlag, Heidelberg 1994 zu entnehmen ist, läßt sich aus diesem MR-Datensatz einerseits der räumliche Verlauf des Gefäßsystems ohne die sonstigen anatomischen Strukturen darstellen und andererseits die anatomischen Strukturen ohne daß Gefäßsystem.

Danach wird im Block 102 ein zweiter MR-Datensatz E(x, y, z) akquiriert, der die Kernmagnetisierungsverteilung in demselben räumlichen Bereich darstellt wie der erste MR-Datensatz. Dieser zweite Datensatz muß in zeitlicher Nähe zum ersten Daten akquiriert werden - z.B. unmittelbar danach - damit das weitere Verfahren nicht durch Bewegungen gestört wird, die zwischen der Akquisition dieser Datensätze im Untersuchungsbereich stattgefunden haben. Die Sequenzen für die Akquisition dieses zweiten MR-Datensatzes sollen den Sequenzen - z.B. hinsichtlich Echozeit und Repetitionszeit - entsprechen, mit denen im weiteren Verlauf des Verfahrens die MR-Daten für einzelne Schichten akquiriert werden. Dann ist sichergestellt, daß ein aus diesen MR-Daten abgeleitetes Schichtbild und das aus dem zweiten MR-Datensatz abgeleitete Bild der gleichen Schicht die anatomischen Strukturen mit dem gleichen Kontrastverhältnis darstellen, so daß aus einem Vergleich der Bilder die Verschiebungen im Untersuchungsbereich bestimmt werden können, die zwischenzeitlich stattgefunden haben. Wenn bereits der erste MR-Datensatz (bzw. ein darin enthaltener Teil-Datensatz) diese Voraussetzung erfüllt, kann die Akquisition des zweiten MR-Datensatzes (Schritt 102) entfallen.

Die Schritte 101 und ggf. 102 werden ausgeführt, bevor das abzubildende Objekt, d.h. der Katheter, in den Patienten eingeführt wird. Alle darauf folgenden Schritten werden erst nach der Einführung des Katheters ausgeführt. Nach der Einführung des Katheters wird einerseits dessen Position P(u,v, t) - im Schritt 103 - gemessen, und andererseits werden im Schritt 104 die MR-Daten einer Schicht akquiriert, in der sich der Katheter momentan befindet. Die Schritte 103 und 104 können unabhängig voneinander erfolgen, jedoch sollten die Schritte in zeitlicher Nähe zueinander ausgeführt werden, so daß das Schichtbild und die MR-Messung jeweils bei derselben Lage des Katheters 10 erzeugt werden.

In Fig. 4 sind zwei Sequenzen dargestellt, durch die MR-Signale einerseits in der Mikrospule 11 und andererseits in der Empfangsspule 15 induziert werden, so daß die Positionsmessung quasi gleichzeitig mit der Akquisition der MR-Daten für ein Schichtbild erfolgt. Gemäß Fig. 4 wird ein Hochfrequenzimpuls (1.Zeile von Fig. 4) in Verbindung mit einem Schichtselektions-Gradienten G_{w} erzeugt, wodurch die Kernmagnetisierung innerhalb einer zur w-Richtung senkrechten Schicht angeregt wird, in der sich jeweils der Katheter 10 befindet. Die w-Richtung kann dabei mit einer der Richtungen x, y oder z zusammenfallen, in denen die von den Gradientenspulen 3..5 erzeugten Magnetfelder einen Gradienten aufweisen, jedoch kann w auch schräg zu den x-, y-, z- Koordinatensystem verlaufen. Nach dem schichtselektiven Hochfrequenzimpuls werden zwei magnetische Gradientenfelder Gᵤ und Gᵥ in den zueinander und zur w-Richtung senkrechten Richtungen u und v (3. und 4. Zeile von Fig.4) erzeugt, wobei die MR-Signale empfangen werden (5. Zeile) während die Gradienten Gᵤ und Gᵥ noch wirksam sind. Diese Sequenz wird mit einer Repetitionszeit Tᵣ wiederholt, wobei von Sequenz zu Sequenz die Gradienten Gᵤ und Gᵥ so variiert werden, daß der Betrag des resultierenden Gradientenfeldes konstant bleibt, während eine Richtung von Sequenz zu Sequenz geändert wird.

Infolge der Frequenzkodierung durch die Gradienten Gᵤ und Gᵥ liefert die Mikrospule 11 bei diesen Sequenzen MR-Signale, deren Frequenz die Lage der Mikrospule in der jeweils wirksamen Gradientenrichtung kennzeichnet. Aus zwei dieser Sequenzen mit vorzugsweise 90° gegeneinander versetzte Lesegradienten läßt sich daher die Lage P(u,v,t) der Mikrospule innerhalb der Schicht und mittels einer zusätzlichen Messung (mit in w-Richtung verlaufenden Gradienten) auch ihr Abstand von der Schicht bestimmen (Block 103). - Die Position der Mikrospule kann aber auch mit anderen MR-Sequenzen oder ganz anderen Verfahren bestimmt werden, z.B. den Verfahren, die in der einleitend genannten Veröffentlichung angegeben sind.

Aus den während der Sequenzen nach Fig 4 von der Empfangsspule 15 empfangenen MR-Signalen läßt sich mit diesem sogenannten Projektions-Rekonstruktions-Verfahren in bekannter Weise die Kernmagnetisierungsverteilung innerhalb der Schicht rekonstruieren (Schritt 104). Das mit Hilfe der aus den MR-Signalen abgeleiteten MR-Daten rekonstruierte Schichtbild I(u, v, t) stellt die anatomischen Strukturen innerhalb der Schicht im Zeitpunkt t dar, in dem die MR-Signale akquiriert wurden. - Auf diese Weise können die in Fig. 4 dargestellten Sequenzen gleichzeitig zur Akquisition der MR-Daten eines Schichtbildes und zur Messung der Position des Katheters 10 herangezogen werden.

In Fig. 5 ist das Schichtbild I(u, v, t) dargestellt, in dem die in der untersuchten Schicht enthaltene anatomische Struktur abgebildet wird. Außerdem ist die Position P der Spitze des Katheters, die zeitgleich mit den MR-Daten der Schicht gemessen wurde, in das Bild I (u, v, t) eingezeichnet.

In Fig. 5 ist außerdem mit A (u, v, t₀) ein Angiogramm dargestellt, das aus dem - zur Zeit t₀ akuirierten - ersten Datensatz A(x, y, z, t₀) abgeleitet ist und das das Gefäßsystem beispielsweise in der gleich Schicht darstellt, deren Anatomie bzw. Morphologie in dem Schichtbild I (u, v, t) enthalten ist. Auch in dieses Bild ist die Position der Katheterspitze eingeblendet und man erkennt, daß diese Position nicht mit einem Gefäß zusammenfällt. Eine mögliche Ursache ist in Bewegungen des Patienten in dem Zeitraum zwischen der Akquisition des ersten MR-Datensatzes und der jeweiligen Messung der Position P zu sehen.

Um diese Bewegungen quantitativ zu erfassen, wird im Schritt 105, der aus dem zweiten MR-Datensatz E(x, y, z, t₀) oder - falls die Sequenzen des ersten MR-Datensatzes die anatomischen Strukturen mit dem gleichen Kontrastverhältnis wiedergeben wie die Sequenzen, mit denen die MR-Daten für das Schichtbild I(u,v,t) wiedergegeben werden - aus dem ersten MR-Datensatz A(x, y, z, t₀) ein MR-Bild I'(u,v,t₀) rekonstruiert. Das ebenfalls in Fig.5 dargestellte Bild I'(u,v,t₀) unterscheidet sich vom MR-Schichtbild I(u,v,t) dadurch, daß die hierfür erforderlichen MR-Daten zur Zeit t₀ akquiriert wurden, während die Akquisition der MR-Daten für das Schichtbild I(u,v,t) - und die Messung der Position P - zur Zeit t erfolgte. Aus einem Vergleich beider Bilder läßt sich daher die Verschiebung T(u,v) bestimmen, die im Zeitraum t₀ - t stattgefunden hat.

Diese Bestimmung erfolgt im Schritt 106. Zu diesem Zweck wird eines der beiden Bilder I(u,v,t) oder I'(u,v,t) in einer Anzahl von z.B. quadratischen Ausschnitten (mit einer Kantenlänge von z.B. 100 Bildelementen) unterteilt, und es wird im jeweils anderen Bildfenster innerhalb eines Suchbereichs um die Position dieses Ausschnitts derjenige Bildausschnitt ermittelt, der mit dem betreffenden Bildausschnitt in einem Bild am besten übereinstimmt. Aus der Lage dieser übereinstimmenden Bildausschnitte läßt sich die Verschiebung T (u, v) bestimmen. Diese ist in dem Bild I' (u, v, t) durch den Pfeil T(u, v) dargestellt, wobei vereinfachend angenommen ist, daß die Verschiebung in allen Bereichen des Bildes gleich groß ist (reine Translation).

Nachdem auf diese Weise im Schritt 106 die Verschiebung T(u, v) ermittelt worden ist, kann entweder die Position P im Angiogramm oder das MR-Angiogramm selbst korrigiert werden. In Fig. 5 ist mit A_{c} (u,v) ein entsprechend korrigiertes Angiogramm eingezeichnet, in das die Position P - unkorrigiert - eingeblendet ist.

Der Vorteil der Korrektur des MR-Angiogramms besteht darin, daß das Gefäßsystem zumindest näherungsweise in dem Zustand dargestellt wird, in denen es sich zum Zeitpunkt t der Messung der Position P der Katheterspitze befindet. Nachteilig darin ist aber, daß der Rechenaufwand relativ groß ist. Es muß nämlich die Position jedes Bildpunktes im Angiogramm korrigiert werden, und die Verschiebung kann sich ortsabhängig innerhalb des Bildes ändern. Wenn man das Angiogramm selbst unverändert läßt und lediglich die entsprechend der Verschiebung T korrigierte Position der Katheterspitze in das Angiogramm einblendet, ergibt sich ein wesentlich geringerer Aufwand, weil die Verschiebung nur für den Bildausschnitt ermittelt werden muß, der der Position P der Katheterspitze entspricht. Allerdings wird das Gefäßsystem dabei nicht in seiner momentanen Lage dargestellt, sondern nur in der Lage, die es ursprünglich hatte.

Durch ständiges Durchlaufen der aus den Schritten 103...107 gebildeten Verfahrensschleife, wird fortlaufend die Position der Katheterspitze gemessen, die jeweilige Verschiebung gegenüber dem ursprünglichen Zustand bestimmt und das Angiogramm bzw. die gemessene Position entsprechend korrigiert. Um die Position im Angiogramm deutlicher zu machen, kann die Position z.B. als blinkender Punkt oder dergleichen in das Angiogramm A_{c}(u,v) eingeblendet werden, wobei auch die Positionen wiedergegeben werden können, die zuvor schon gemessen worden sind, so daß der Katheter über einen größeren Teil seiner Länge abgebildet wird.

Grundsätzlich wäre es möglich, die aus den Schichtbildern sich ergebenden anatomischen Strukturen zusammen mit dem Gefäßsystem darzustellen, was die Orientierung erleichtern könnte. Der wichtigste Grund für die Akquisition dieser MR-Schichtbilder besteht aber darin, fortlaufend die Verschiebung (Verformung) gegenüber dem Ursprungszustand zu ermitteln und das Angiogramm bzw. die gemessene Katheterposition entsprechend zu korrigieren.

## Patentansprüche

1. MR-Verfahren zur bildgestützten Überwachung der Verschiebung eines Objekts relativ zu einem Gefäßsystem eines Patienten, wobei ein erster MR-Datensatz (A(x,y,z;t₀)) akquiriert wird, der den räumlichen Verlauf des Gefäßsystems innerhalb eines dreidimensionalen Bereiches darstellt, wonach fortlaufend die Position (P(u,v,t)) des Objekts gemessen und in ein aus dem ersten MR-Datensatz abgeleitetes MR-Angiogramm eingeblendet wird, mit den folgenden Vefahrensschritten
a) Akquisition der MR-Daten einer mindestens teilweise zu dem Bereich gehörenden und der Position des Objekts angepaßten Schicht in zeitlicher Nähe zu einer Messung (P(u,v,t)) der Position des Objekts,
b) Rekonstruktion eines Schichtbildes (I(u,v,t)) aus diesen MR-Daten,
**gekennzeichnet durch** folgende Verfahrensschritten
c) Rekonstruktion eines MR-Bildes (I'(u,v,t₀)) der gleichen Schicht aus dem ersten Datensatz (A(x,y,z;t₀)) oder einem in zeitlicher Nähe dazu akquirierten und den dreidimensionalen Bereich darstellenden zweiten MR-Datensatz (E(x,y,z;t₀)),
d) Bestimmung von Verschiebungen (T(u,v)) des Patienten zumindest in der Umgebung des Objekts aus dem Schichtbild und dem MR-Bild,
e) Korrektur der gemessenen Position und/oder des MR-Angiogramms entsprechend den Verschiebungen (T(u,v,t)) des Patienten und anschließende Einblendung der Position des Objekts in das Angiogramm (A_{c}(u,v)),
f) Wiederholung der Schritte a) bis e) für andere Positionen des Objektes.

2. MR-Verfahren nach Anspruch 1, wobei in zeitlicher Nähe zu dem ersten MR-Datensatz (A(x,y,z;t₀)) ein zweiter MR-Datensatz (E(x,y,z;t₀)) akquiriert wird, **dadurch gekennzeichnet, daß** der zweite MR-Datensatz (E(x,y,z;t₀)) und die MR-Daten für die verschiedenen Schichten mit gleichartigen Anregungssequenzen akquiriert werden.

3. MR-Verfahren nach Anspruch 1, **dadurch gekennzeichnet, daß** zur Messung der Position des Objekts wenigstens eine mit dem Objekt verbundene Mikrospule (11) vorgesehen ist, daß zur Akquisition der MR-Daten der Schicht eine Anzahl von Anregungssequenzen erzeugt wird, wobei die Richtung des während der Erfassung des MR-Signales wirksamen magnetischen Gradientenfeldes (Gᵤ, Gᵥ) von Sequenz zu Sequenz variiert wird und daß die Position (P(u,v,t) des Objekts aus MR-Signalen abgeleitet wird, die bei einigen dieser Sequenzen von der Mikrospule empfangen werden.

4. Anordnung zur Durchführung des Verfahrens nach Anspruch 1 mit Mitteln (101) zur Akquisition eines ersten MR-Datensatzes (A(x,y,z;t₀)), der den räumlichen Verlauf des Gefäßsystems eines Patienten innerhalb eines dreidimensionalen Bereiches darstellt, Mitteln (103) zur fortlaufenden Messung der Position (P(u,v,t) eines Objekts (10) und zu deren Einblendung in ein aus dem ersten MR-Datensatz abgeleitetes MR-Angiogramm beinhaltend
a) Mittel (104) zur Messung der MR-Daten einer mindestens teilweise zu dem Bereich gehörenden und der Position des Objekts angepaßten Schicht in zeitlicher Nähe zu einer Messung der Position des Objekts,
b) Mittel (104) zur Rekonstruktion eines Schichtbildes (I(u,v,t)) aus diesen MR-Daten,
**gekennzeichnet durch**
c) Mittel (105) zur Rekonstruktion eines MR-Bildes (I'(u,v,t)) der gleichen Schicht aus dem ersten Datensatz (A(x,y,z;t₀)) oder einem in zeitlicher Nähe dazu akquirierten und den dreidimensionalen Bereich darstellenden zweiten MR-Datensatz (E(x,y,z;t₀)),
d) Mittel (106) zur Bestimmung von Verschiebungen des Patienten zumindest in der Umgebung des Objekts (10) aus dem Schichtbild (I(u,v,t)) und dem MR-Bild (I'(u,v,t₀)),
e) Mittel (106) zur Korrektur der gemessenen Position und/oder des MR-Angiogramms entsprechend den Verschiebungen des Patienten und anschließende Einblendung der Position des Objekts in das Angiogramm (A_{c}(u,v)).

## Claims

1. An MR method for the image-assisted monitoring of the shift of an object relative to a vascular system of a patient, in which method a first MR data set (A(x,y,z;t₀)) is acquired which represents the course in space of the vascular system within a three-dimensional region, after which the position (P(u,v,t)) of the object is continuously measured and reproduced in an MR angiogram derived from the first MR data set, which method includes the following steps:
a) acquisition of the MR data of a slice which belongs at least partly to the region and is adapted to the position of the object, said acquisition taking place in the temporal vicinity of a measurement of the position (P(u,v,t)) of the object,
b) reconstruction of a slice image (I(u,v,t)) from this MR data,
**characterized by** the following steps:
c) reconstruction of an MR image (I'(u,v,t₀)) of the same slice from the first data set A(x,y,z;t₀))or from a second MR data set (E(x,y,z;t₀)) which has been acquired in the temporal vicinity thereof and represents the three-dimensional region,
d) determination of shifts (T(u,v)) of the patient, at least in the vicinity of the object, from the slice image and the MR image,
e) correction of the measured position and/or the MR angiogram in conformity with the shifts (T(u,v,t)) of the patient and subsequent reproduction of the position of the object in the angiogram (A_{c}(u,v)),
f) repetition of the steps a) to e) for other positions of the object.

2. An MR method as claimed in Claim 1, in which a second MR data set (E(x,y,z;t₀)) is acquired in the temporal vicinity of the first MR data set (A(x,y,z;t₀)), **characterized in that** the second MR data set (E(x,y,z;t₀)) and the MR data for the various slices are acquired by means of similar excitation sequences.

3. An MR method as claimed in Claim 1, **characterized in that** at least one microcoil (11) is attached to the object in order to measure the position of the object, that a number of excitation sequences are generated for the acquisition of the MR data of the slice, the direction of the magnetic gradient field (Gᵤ, Gᵥ) active during the acquisition of the MR signal being varied from one sequence to another, and that the position (P(u,v,t)) of the object is derived from MR signals received by the microcoil in response to some of these sequences.

4. A device for carrying out the method claimed in Claim 1, including means (101) for the acquisition of a first MR data set (A(x,y,z;t₀)) which represents the course in space of the vascular system of a patient within a three-dimensional region, and means (103) for continuous measurement of the position (P(u,v,t)) of an object (10) and its reproduction in an MR angiogram derived from the first MR data set,
comprising:
a) means (104) for measuring the MR data of a slice, belonging at least partly to the region and adapted to the position of the object, in the temporal vicinity of a measurement of the position of the object,
b) means (104) for reconstructing a slice image (I(u,v,t)) from this MR data, chacterized by
c) means (105) for reconstructing an MR image (I'(u,v,t)) of the same slice from the first data set (A(x,y,z;t₀)) or from a second MR data set (E(x,y,z;t₀)) which has been acquired in the temporal vicinity thereof and represents the three-dimensional region,
d) means (106) for determining shiftsof the patient, at least in the vicinity of the object (10), from the slice image (I(u,v,t)) and the MR image (I'(u,v,t₀)),
e) means (106) for correcting the measured position and/or the MR angiogram in conformity with the shifts of the patient and subsequent reproduction of the position of the object in the angiogram (A_{c}(u,v)).

## Revendications

1. Procédé de RM de surveillance assistée par imagerie du déplacement d'un objet par rapport à un système vasculaire d'un patient, un premier jeu de données RM (A(x,y,z;t0)) qui représente le tracé spatial du système vasculaire dans une zone tridimensionnelle étant acquis, après quoi la position (P(u,v,t)) de l'objet est mesurée en continu et est superposée dans un angiogramme de RM dérivé du premier jeu de données RM, comportant les étapes suivantes du procédé:
a) acquisition des données RM d'une couche appartenant à la zone, du moins en partie, et adaptée à la position de l'objet à proximité temporelle d'une mesure (P(u,v,t)) de la position de l'objet,
b) reconstruction d'une image de la couche (I(u,v,t)) à partir de ces données RM,
**caractérisé par** les étapes suivantes du procédé:
c) reconstruction d'une image RM (I'(u,v,t0)) de la même couche à partir du premier jeu de données (A(x,y,z;t0)) ou d'un deuxième jeu de données (E(x,y,z;t0)) acquis à proximité temporelle de celui-ci et représentant la zone tridimensionnelle,
d) détermination de déplacements (T(u,v)) du patient, du moins dans les environs de l'objet de l'image de la couche et de l'image RM;
e) correction de la position mesurée et/ou de l'angiogramme de RM correspondant aux déplacements (T(u,v,t)) du patient et superposition consécutive de la position de l'objet dans l'angiogramme (Ac(u,v)),
f) répétition des étapes a) à e) pour d'autres positions de l'objet.

2. Procédé RM selon la revendication 1, un deuxième jeu de données RM (E(x,y,z;t0)) étant acquis à proximité temporelle du premier jeu de données RM (A(x,y,z;t0)), **caractérisé en ce que** le deuxième jeu de données RM (E(x,y,z;t0)) et les données RM pour les différentes couches sont acquises avec des séquences d'excitation similaires.

3. Procédé RM selon la revendication 1, **caractérisé en ce que**, pour la mesure de la position de l'objet, au moins une microbobine (11) reliée à l'objet est prévue, que, pour l'acquisition des données RM de la couche, plusieurs séquences d'excitation sont produites, la direction du champ à gradient magnétique (Gu, Gv) actif pendant la saisie du signal RM variant d'une séquence à l'autre et que la position (P(u,v,t) de l'objet est dérivée de signaux RM qui sont reçus par la microbobine pour certaines de ces séquences.

4. Dispositif de mise en oeuvre du procédé selon la revendication 1 avec des moyens (101) pour l'acquisition d'un premier jeu de données RM (A(x,y,z; t0)) qui représente le tracé spatial du système vasculaire d'un patient à l'intérieur d'une zone tridimensionnelle, des moyens (103) pour la mesure continue de la position (P(u,v,t) d'un objet (10) et pour sa superposition dans un angiogramme de RM dérivé du premier jeu de données RM,
contenant
a) des moyens (104) pour la mesure des données RM d'une couche appartenant à la zone, du moins en partie, et adaptée à la position de l'objet à proximité temporelle d'une mesure de la position de l'objet,
b) des moyens (104) de reconstruction d'une image de la couche (I(u,v,t)) à partir de ces données RM,
**caractérisé par**
c) des moyens (105) de reconstruction d'une image RM (I'(u,v,t)) de la même couche à partir du premier jeu de données (A(x,y,z;t0)) ou d'un deuxième jeu de données (E(x,y,z;t0)) acquis à proximité temporelle de celui-ci et représentant la zone tridimensionnelle,
d) des moyens de détermination de déplacements (T(u,v)) du patient, du moins dans les environs de l'objet de l'image de la couche (I(u,v,t)) et de l'image RM (I'(u, v, t0));
e) des moyens de correction de la position mesurée et/ou de l'angiogramme de RM correspondant aux déplacements du patient et de superposition consécutive de la position de l'objet dans l'angiogramme (Ac(u,v)).
